Europäisches Patentamt

European Patent Office

Office européen des brevets

(11) Publication number: **0 466 248 A1**

# EUROPEAN PATENT APPLICATION

(21) Application number: **91201694.6**

(22) Date of filing: **02.07.91**

(51) Int. Cl.5: **B26B 19/38**, H05K 5/00

(30) Priority: **09.07.90 NL 9001559**

(43) Date of publication of application:
**15.01.92 Bulletin 92/03**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Mous, Frans**
**c/o INT. OCTROOIBUREAU B.V. Prof.**
**Holstlaan 6**
**NL-5656 AA Eindhoven(NL)**

(74) Representative: **Bos, Kornelis Sjoerd et al**
**INTERNATIONAAL OCTROOIBUREAU B.V.**
**Prof. Holstlaan 6**
**NL-5656 AA Eindhoven(NL)**

(54) Housing-half fastening arrangement.

(57) A housing-half quick-fastening arrangement, for example for a domestic appliance, comprises a fastening element (6) of U-shaped cross-section with a central portion (7) at the location of facing peripheral portions (8,9) of the housing halves (4,5), the limbs (10, 11) of the U-shaped fastening element at least partly engaging around the housing halves. The central portion (7) of the fastening element comprises a retaining element (12) of mushroom-shaped cross-section with a shank (13) situated between the housing halves and with a head (14) which engages behind the housing halves in the interior of the housing.

FIG.2

The invention relates to a housing-half quick-fastening arrangement, for example for a domestic appliance, comprising a fastening element of U-shaped cross-section with a central portion at the location of facing peripheral portions of the housing halves, the limbs of the U-shaped fastening element at least partly engaging around the housing halves.

Such a housing-half fastening arrangement is known, for example from DE-A-31 19 018. The limbs of this known fastener comprise inwardly directed lugs engaging in corresponding grooves in the housing halves.

The invention provides a housing-half fastening arrangement which affects the shape and construction of the housing halves to the least possible extent and is characterized in that the central portion of the fastening element comprises a retaining element of mushroom-shaped cross-section with a shank situated between the housing halves and with a head which engages behind the housing halves in the interior of the housing.

Special embodiments have been defined in the subsidiary Claims.

The invention will now be described in more detail with reference to the Figures, which show an exemplary embodiment.

Figure 1 is a perspective view of a shaving apparatus employing the housing-half fastening arrangement in accordance with the invention.

Figure 2 is a cross-sectional view of a part, taken on the line II-II in Figure 1.

Figure 3 is a detail of a view of the housing at the location of the facing peripheral portions of the housing halves.

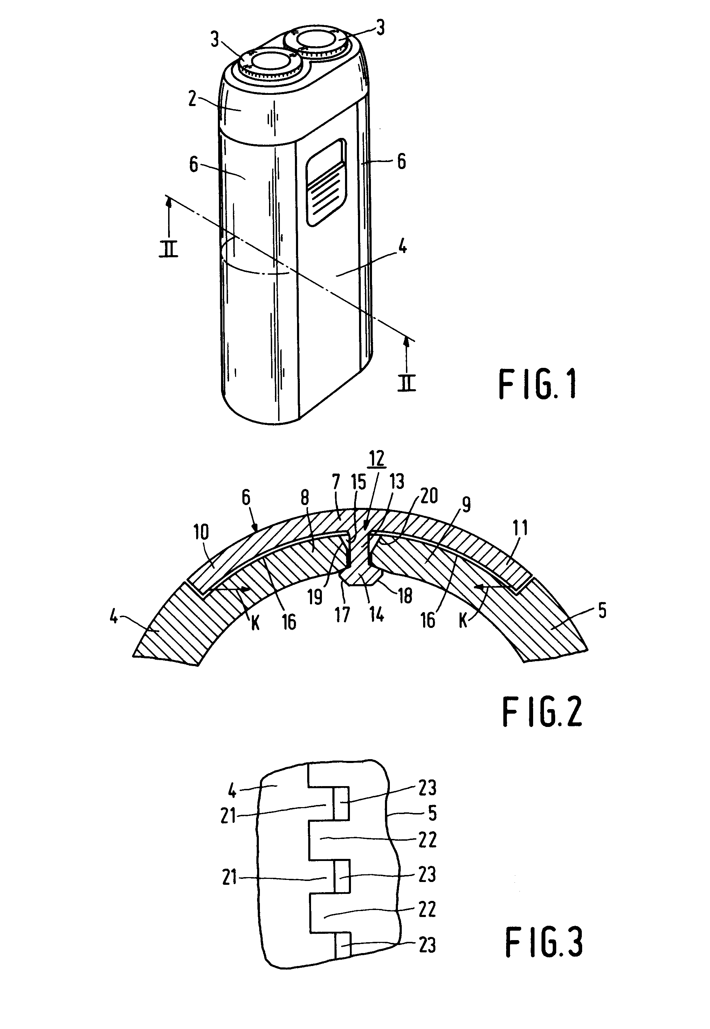

The shaving apparatus shown in Figures 1 to 3 comprises a housing 1 with a shaving head 2 having two shaving units 3.

The housing 1 comprises two housing halves 4 and 5 which are secured to one another by two identical fastening elements 6.

A fastening element 6 is of U-shaped cross-section (Figure 2) with a central portions 7 at the location of the facing peripheral portions 8 and 9 of the housing halves 4 and 5 respectively.

The limbs 10 and 11 of the fastening element 6 partly engage around the housing halves 4 and 5 respectively, resulting in clamping forces K which hold the housing halves together.

The central portion 7 of the fastening element 6 comprises a retaining element 12 of mushroom-shaped cross-section with a shank 13 situated between the peripheral portions 8 and 9 and with a head 14 engaging behind the housing halves in the interior of the housing. The fastening element 6 is thus secured to the housing 1.

The fastening element 6 can be mounted simply and quickly by placing the housing halves onto each other and subsequently pressing the retaining element 12 into the seam 15 between the peripheral portions 8 and 9 until the head 14 snaps behind the housing halves 4 and 5. This results in a slight elastic deformation of the limbs 10 and 11, causing them to engage tightly with the housing halves. Tools and separate fixing means such as bolts are not needed. Moreover, it is not necessary to form the housing halves with grooves for the fastening element. In order to obtain a smooth housing surface the housing halves 4 and 5 may be provided with re-entrant portions 16 adjoining the seam 15 to take up the limbs 10 and 11.

The fastening element 6 is preferably constructed as an integral plastics part. To facilitate mounting the head 14 may be provided with bevels 17 and 18 and the peripheral portions 8 and 9 may be provided with bevels 19 and 20 respectively.

The retaining element 12 may extend over the entire length of the fastening element 6 to provide a correct sealing of the seam 15.

However, alternatively, the fastening element 6 may be provided with a plurality of spaced-apart retaining elements. The housing halves may then be constructed as shown in Figure 3, in which for the sake of clarity the fastening element itself is not shown. The housing halves 4 and 5 comprise facing projections 21 and 22 respectively which interengage in such a way that openings 23 are left for the shanks 13 of the retaining elements 12. This also ensures that the fastening elements 6 are locked in the longitudinal direction.

By means of the fastening elements described above it is possible to achieve an effective sealing of the seam between the housing halves, thereby enabling the electrical safety requirements imposed on the apparatus to be met in a simple way.

**Claims**

1. A housing-half quick-fastening arrangement, for example for a domestic appliance, comprising a fastening element of U-shaped cross-section with a central portion at the location of facing peripheral portions of the housing halves, the limbs of the U-shaped fastening element at least partly engaging around the housing halves, characterized in that the central portion of the fastening element comprises a retaining element of mushroom-shaped cross-section with a shank situated between the housing halves and with a head which engages behind the housing halves in the interior of the housing.

2. A housing-half quick-fastening arrangement as claimed in Claim 1, comprising an elongate fastening element which extends along a seam of the housing, characterized in that the central portion comprises a single retaining element which extends in the longitudinal direction.

3. A housing-half quick-fastening arrangement as claimed in Claim 1, comprising an elongate fastening element which extends along a seam of the housing, characterized in that the central portion comprises a plurality of spaced-apart retaining elements.

4. A housing-half quick-fastening arrangement as claimed in Claim 3, characterized in that the housing halves comprise interengaging portions which leave openings for the retaining elements.

FIG.1

FIG.2

FIG.3

**European Patent Office**

# EUROPEAN SEARCH REPORT

Application Number

**EP 91 20 1694**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A,D | DE-A-3 119 018 (MATSUSHITA ELECTRIC WORKS LTD) <br> – – – | 1 | B 26 B 19/38 <br> H 05 K 5/00 |
| A | DE-A-3 742 557 (SUEDDEUTSCHE KUEHLERFABRIK JULIUS BEHR GMBH) <br> * column 3 - column 4; figures 1,2 * * <br> – – – – – | 1 | |

**TECHNICAL FIELDS SEARCHED (Int. Cl.5)**

B 26 B
H 05 K
B 29 C

The present search report has been drawn up for all claims

| Place of search | Date of completion of search | Examiner |
|---|---|---|
| The Hague | 18 October 91 | WOHLRAPP R.G. |

CATEGORY OF CITED DOCUMENTS

X : particularly relevant if taken alone
Y : particularly relevant if combined with another
document of the same catagory
A : technological background
O : non-written disclosure
P : intermediate document
T : theory or principle underlying the invention

E : earlier patent document, but published on, or after
the filing date
D : document cited in the application
L : document cited for other reasons

& : member of the same patent family, corresponding
document